# EUROPEAN PATENT APPLICATION

(11) **EP 3 813 128 A1**
(43) Date of publication of application: **28.04.2021**
(21) Application number: 20202747.0
(22) Date of filing: 20.10.2020
(51) Int. Cl.: H01L 31/0352, H01L 31/11

(54) **OPTOELECTRIC DEVICE**

(30) Priority: 23.10.2019 KR 20190132387
(71) Applicant: Samsung Electronics Co., Ltd., Gyeonggi-do 16677 (KR)
(72) Inventor: CHO, Kyungsang, 16678 Suwon-si, Gyeonngi-do (KR)
(74) Representative: Grünecker Patent- und Rechtsanwälte PartG mbB

(57) **Abstract**

An optoelectric device includes a quantum dot core and an intermediate provided on at least a part of a surface of the quantum dot core, thereby converting light energy incident upon the optoelectric device to electrical energy.

## Description

### BACKGROUND

### 1. Field

Example embodiments of the disclosure relate to an optoelectric device.

### 2. Description of Related Art

A quantum dot (QD) is a nanocrystal made of a semiconductor material having a diameter of about 10 nm or less and having a quantum confinement effect.

Colloidal quantum dots have been applied to various optoelectric devices. For example, quantum dots have been applied to light-emitting devices such as QD-TVs, QD-LEDs, or QD-displays, or to optoelectric devices such as QD-photodetectors or QD-solar cells. When quantum dots are applied to a light-emitting device and an optoelectric device, energy band characteristics of the quantum dots may be expressed differently. In other words, energy band characteristics of quantum dots applied to a light-emitting device may be different from those of quantum dots applied to a different optoelectric device. When a light-emitting device uses a core/shell structure, it is advantageous to implement superior light-emission efficiency. However, an optoelectric device such as a solar cell does not use the core/shell structure. This is because, when a bandgap of the shell is greater than that of the core in the core/shell structure, the efficiency of extraction of carriers generated in the core to the outside may deteriorate.

### SUMMARY

Example embodiments provide an optoelectric device having efficient optoelectric performance.

Additional aspects will be set forth in part in the description which follows and, in part, will be apparent from the description, or may be learned by practice of the presented embodiments of the disclosure.

In accordance with an aspect of an example embodiment, an optoelectric device includes a quantum dot core; and an intermediate provided on at least a part of a surface of the quantum dot core, wherein the optoelectric device is configured to convert light energy incident upon the optoelectric device to electrical energy.

The optoelectric device may further include a matrix in which the quantum dot core and the intermediate are embedded and through which carriers are transferred, the carriers being generated by the quantum dot core from the incident light energy.

A ratio of an area of the part of the surface of the quantum dot core to an entire area of the surface of the quantum dot core may be in a range of 0.001-0.5.

A ratio of an area of the part of the surface of the quantum dot core to an entire area of the surface of the quantum dot core may be in a range of 0.001-0.3.

The quantum dot core may include at least one selected from a group consisting of CdSe, CdTe, InP, InAs, ZnS, ZnSe, and ZnTe.

The intermediate may include at least one selected from a group consisting of PbS, PbSe, InP, InAs, and AlAs.

The intermediate may include sulfur (S) or oxygen (O).

The matrix may include a semiconductor material.

The matrix may include an indium gallium zinc oxide (IGZO), a silicon indium zinc oxide (SIZO), or a silicon zinc tin oxide (SZTO).

The matrix may include a group IV semiconductor material, a group III-V semiconductor material, or a group II-VI semiconductor material.

The matrix may include a-Si, p-Si, Ge, GaAs, GaP, GaN, ZnSe, or ZnS.

When a majority of carriers generated by the quantum dot core includes electrons, a conduction energy band level of the intermediate may be lower than a conduction energy band level of the quantum dot core.

When a majority of carriers generated by the quantum dot core includes holes, a valence energy band level of the intermediate may be higher than a valence energy band level of the quantum dot core.

A first electrode may be provided at a first side of the matrix and a second electrode may be provided at a second side of the matrix opposite to the first side.

A third electrode may be provided on a bottom side of the matrix, the bottom side being different from the first side and the second side, and an insulating layer may be provided between the matrix and the third electrode.

In accordance with an aspect of an example embodiment, a quantum dot structure includes a quantum dot core including a first material having a first valence band level and a first conduction band level; and a surface layer partially covering a surface of the quantum dot core, the surface layer including a second material having a second valence band level and a second conduction band level, wherein the first valence band level is less than the second valence band level or the first conduction band level is greater than the second conduction band level.

The first valence band level may be less than the second valence band level.

The first conduction band level may be greater than the second conduction band level.

A ratio of an area of a portion of the surface of the quantum dot core covered by the surface layer to an entire area of the surface of the quantum dot core may be in a range of 0.001-0.5.

A ratio of an area of a portion of the surface of the quantum dot core covered by the surface layer to an entire area of the surface of the quantum dot core may be in a range of 0.001-0.3.

### BRIEF DESCRIPTION OF THE DRAWINGS

The above and other aspects, features, and advantages of certain example embodiments will be more apparent from the following description taken in conjunction with the accompanying drawings, in which:
FIG. 1 schematically illustrates an optoelectric device according to an example embodiment;
FIGS. 2 to 7 are energy band diagrams of an optoelectric device according to an example embodiment;
FIG. 8 schematically illustrates an optoelectric device according to an example embodiment;
FIG. 9 illustrates an optoelectric device according to an example embodiment;
FIG. 10 illustrates an optoelectric device according to a comparative example;
FIG. 11 illustrates a voltage-current characteristics graph of an optoelectric device according to a comparative example;
FIG. 12 is a graph showing responsivity according to voltage of an optoelectric device according to a comparative example, with respect to three power levels;
FIG. 13 is a graph showing voltage-current characteristics of an optoelectric device according to an example embodiment;
FIG. 14 is a graph showing responsivity according to voltage of an optoelectric device according to an example embodiment, with respect to three power levels; and
FIG. 15 is a graph showing time-resolved photoluminescence data of an optoelectric device according to an example embodiment.

### DETAILED DESCRIPTION

Reference will now be made in detail to embodiments, examples of which are illustrated in the accompanying drawings. In this regard, example embodiments may have different forms and should not be construed as being limited to the descriptions set forth herein. Accordingly, example embodiments are described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Optoelectric devices according to various example embodiments are described below in detail with reference to the accompanying drawings. In the drawings, like reference numerals refer to like elements throughout, and the size of each layer illustrated in the drawings may be exaggerated for convenience of explanation and clarity Terms such as "first" and "second" are used herein merely to describe a variety of constituent elements, but the constituent elements are not limited by the terms. Such terms are used only for the purpose of distinguishing one constituent element from another constituent element.

The expression of singularity includes the expression of plurality unless clearly specified otherwise in context. It will be further understood that the terms "comprises", "comprising", "includes", and "including" used herein specify the presence of stated features or components, but do not preclude the presence or addition of one or more other features or components. Furthermore, the size or thickness of each element illustrated in the drawings may be exaggerated for convenience of explanation and clarity. Furthermore, when a material layer is described to exist on another layer, the material layer may exist directly on the other layer or one or more layers may be interposed therebetween. Since a material forming each layer in the following embodiments is an example, other materials may be used therefor.

Furthermore, terms such as "unit", "module", etc. may signify a unit or module to process at least one function or operation and the unit or module may be embodied by hardware, software, or a combination of hardware and software.

The particular implementations shown and described herein are illustrative examples of the disclosure and are not intended to otherwise limit the scope of the disclosure in any way. For the sake of brevity, conventional electronics, control systems, software development and other functional aspects of the systems may not be described in detail. Furthermore, the connecting lines, or connectors shown in the various figures presented are intended to represent functional relationships and/or physical or logical couplings between the various elements.

The use of the terms "a" and "an" and "the" and similar referents in the context of describing the disclosure are to be construed to cover both the singular and the plural.

Also, the steps of all methods described herein can be performed in any suitable order unless otherwise indicated herein or otherwise clearly contradicted by context. Furthermore, the use of any and all examples, or language (e.g., "such as") provided herein, is intended merely to better illuminate the disclosure and does not pose a limitation on the scope of the disclosure unless otherwise claimed.

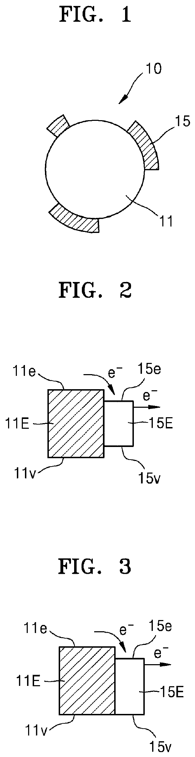

FIG. 1 schematically illustrates an optoelectric device 10 according to an example embodiment.

Referring to FIG. 1, the optoelectric device 10 (i.e., quantum dot structure) may include a quantum dot core 11 and at least one intermediate 15 provided on a part of a surface of the quantum dot core 11. The intermediate 15 may refer to a shell-like layer provided on a surface of the quantum dot core 11 that partially or fully covers the surface of the quantum dot core 11. It is also referred to as "surface layer" in the present application. The quantum dot core 11 may be, for example, spherical. However, the shape of the quantum dot core 11 is not limited thereto. The intermediate 15 may be provided on the entire surface of the quantum dot core 11 or on a part of the surface thereof. An area ratio of the intermediate 15 covering the surface of the quantum dot core 11 may be adjusted.

The area ratio of the intermediate 15 covering the surface of the quantum dot core 11 is referred to as the coverage. In other words, the coverage of the intermediate 15 with respect to the quantum dot core 11 may be a ratio of an area of the part of the surface of the quantum dot core 11 that is covered by the intermediate 15 to an entire area of the surface of the quantum dot core 11. The intermediate 15 may include one intermediate or a plurality of intermediates. The intermediates 15 may be arranged spaced apart from each other. Optoelectric efficiency by interaction between the quantum dot core 11 and the intermediate 15 may vary according to the coverage of the intermediate 15. For example, the intermediate 15 may have a coverage in a range of 0.001-0.5 with respect to the quantum dot core 11. The coverage is based on the intermediate 15 being a monolayer. Alternatively, the intermediate 15 may have a coverage in a range of 0.001-0.3 with respect to the quantum dot core 11. Alternatively, the intermediate 15 may have a coverage in a range of 0.001-0.2 with respect to the quantum dot core 11. When the intermediate 15 is provided on a part of the surface of the quantum dot core 11, the optoelectric efficiency may be high compared to a case in which the intermediate 15 is provided on the entire surface of the quantum dot core 11.

The quantum dot core 11 may include, for example, at least one selected from the group consisting of CdSe, CdTe, InP, InAs, ZnS, ZnSe, and ZnTe. The intermediate 15 may include, for example, at least one selected from the group consisting of PbS, PbSe, InP, InAs, and AlAs. The intermediate may also or instead be configured to prevent oxidation of the quantum dot core by including sulfur (S) or oxygen (O).

FIGS. 2 to 7 are energy band diagrams of an optoelectric device according to an example embodiment.

FIGS. 2, 3, and 4 are energy band diagrams of an optoelectric device including an n-type quantum dot core in which electrons are a majority of carriers. For example, a conduction energy band level 15e (i.e., a second conduction band level) of an intermediate 15E (i.e., an intermediate) may be lower than a conduction energy band level 11e (i.e., a first conduction band level) of a quantum dot core 11E.

An optoelectric device according to an example embodiment has a relatively high carrier extraction efficiency, compared to a core quantum dot (core QD) structure. Charges generated in a quantum dot core may be easily extracted over a low conduction energy band level of an intermediate.

In FIG. 2, the conduction energy band level 15e of intermediate 15E is lower than the conduction energy band level 11e of the quantum dot core 11E, and a valence energy band level 15v of the intermediate 15E is higher than a valence energy band level 11v of the quantum dot core 11E.

In FIG. 3, the conduction energy band level 15e of the intermediate 15E is lower than the conduction energy band level 11e of the quantum dot core 11E, and the valence energy band level 15v of the intermediate 15E is equal to the valence energy band level 11v of the quantum dot core 11E.

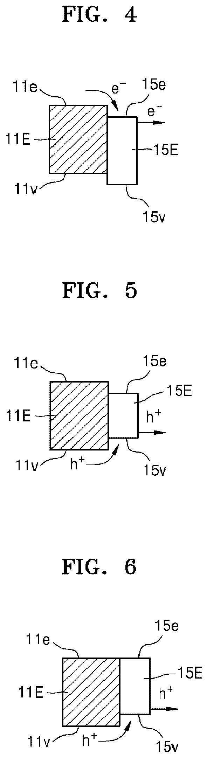

In FIG. 4, the conduction energy band level 15e of the intermediate 15E is lower than the conduction energy band level 11e of the quantum dot core 11E, and the valence energy band level 15v of the intermediate 15E is lower than the valence energy band level 11v of the quantum dot core 11E.

When the conduction energy band level of the intermediate is lower than the conduction energy band level of a quantum dot core, electrons (e-) generated by the light from the quantum dot may be efficiently extracted to the intermediate 15E. In the cases illustrated in FIGS. 2, 3, and 4, the position of the valence energy band level of the intermediate is not related to the electron extraction efficiency.

FIGS. 5, 6, and 7 illustrate an optoelectric device including p-type quantum dots in which a majority of carriers are holes. In this case, in contrast to that of an optoelectric device including n-type quantum dots illustrated in FIGS. 2, 3, and 4, in connection with the hole extraction efficiency, the valence energy band level of the intermediate 15E is important and the conduction energy band level thereof has no relation.

In FIG. 5, the valence energy band level 15v (i.e., the second valence band level) of the intermediate 15E is higher than the valence energy band level 11v (i.e., the first valence band level) of the quantum dot core 11E, and the conduction energy band level 15e of the intermediate 15E is lower than the conduction energy band level 11e of the quantum dot core 11E. In FIG. 6, the valence energy band level 15v of the intermediate 15E is higher than the valence energy band level 11v of the quantum dot core 11E, and the conduction energy band level 11e of the quantum dot 11E is equal to the conduction energy band level 15e of the intermediate 15E.

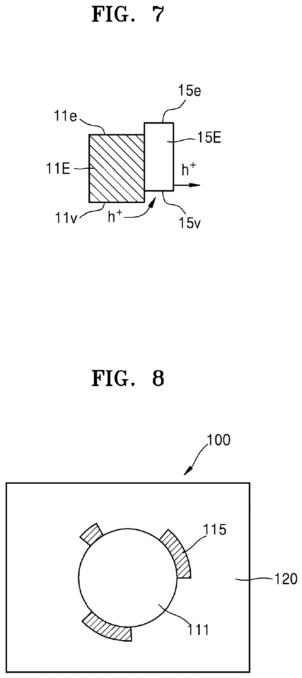

In FIG. 7, the valence energy band level 15v of the intermediate 15E is higher than the valence energy band level 11v of the quantum dot core 11E, and the conduction energy band level 15e of the intermediate 15E is higher than the conduction energy band level 11e of the quantum dot core 11E. When the valence energy band level 15v of the intermediate 15E is higher than the valence energy band level 11v of the quantum dot core 11E, holes (h+) generated by the light from the quantum dot core may be efficiently extracted to the intermediate 15E.

FIG. 8 schematically illustrates an optoelectric device 100 according to an example embodiment.

The optoelectric device 100 may include a quantum dot core 111, at least one intermediate 115 provided on a part of a surface of the quantum dot core 111, and a matrix 120 in which the quantum dot core 111 and the intermediate 115 are embedded. As the quantum dot core 111 and the intermediate 115 are substantially the same as the quantum dot core 11 and the intermediate 15 described above with reference to FIG. 1, detailed descriptions thereof are omitted.

The matrix 120 may efficiently transfer carriers generated by the light from the quantum dot core 111 to an electrode. The quantum dot core 111 and the intermediate 115 may be embedded in the matrix 120.

For a phototransistor formed of a quantum dot structure only without a matrix, carrier mobility in the quantum dot structure is low so that carriers may not be efficiently transferred. The quantum dot structure denotes a structure including the quantum dot core 111 and the intermediate 115. On the other hand, when the quantum dot structure is embedded in the matrix 120, carrier transfer efficiency of the optoelectric device may be relatively high compared to a case in which the quantum dot structure is located above or under the matrix 120.

The matrix may transport the carriers generated by the light from the quantum dot core. The matrix may include, for example, an oxide semiconductor. The oxide semiconductor may include, for example, at least one of a ZnO-based oxide, an InO-based oxide, or a SnO-based oxide.

The oxide semiconductor may include at least one of a silicon indium zinc oxide (SIZO), a silicon zinc tin oxide (SZTO), a zinc oxide (ZnO), an indium zinc oxide (IZO), a zinc tin oxide (ZTO), an indium gallium zinc oxide (IGZO), a hafnium indium zinc oxide (HIZO), an indium zinc tin oxide (IZTO), a tin oxide (SnO), an indium tin oxide (ITO), an indium gallium oxide (IGO), an indium oxide (InO), or an aluminum indium oxide (AIO).

The matrix may include a group IV semiconductor material, a group III-V semiconductor material, or a group II-VI semiconductor material.

The group IV semiconductor material may include, for example, Si, Ge, SiGe, SiC, or a combination thereof.

The group III-V semiconductor material may include, for example, at least one of a binary compound such as GaN, GaP, GaAs, GaSb, AIN, AIP, AlAs, AlSb, InN, InP, InAs, or InSb; a ternary compound such as GaNP, GaNAs, GaNSb, GaPAs, GaPSb, AINP, AINAs, AINSb, AlPAs, AlPSb, InNP, InNAs, InNSb, InPAs, or InPSb; or a quaternary compound such as GaAINP, GaAINAs, GaAINSb, GaAIPAs, GaAIPSb, GalnNP, GalnNAs, GalnNSb, GalnPAs, GaInPSb, InAINP, InAINAs, InAINSb, InAIPAs, or InAIPSb, or a combination thereof.

The group II-VI semiconductor material may include, for example, a binary compound such as CdS, CdSe, CdTe, ZnS, ZnSe, ZnTe, ZnO, HgS, HgSe, or HgTe; a ternary compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, or HgZnSe; or a quaternary compound such as CdHgZnTe, CdZnSeS, CdZnSeTe, CdZnSTe, CdHgSeS, CdHgSeTe, CdHgSTe, HgZnSeS, HgZnSeTe, or HgZnSTe, or a combination thereof.

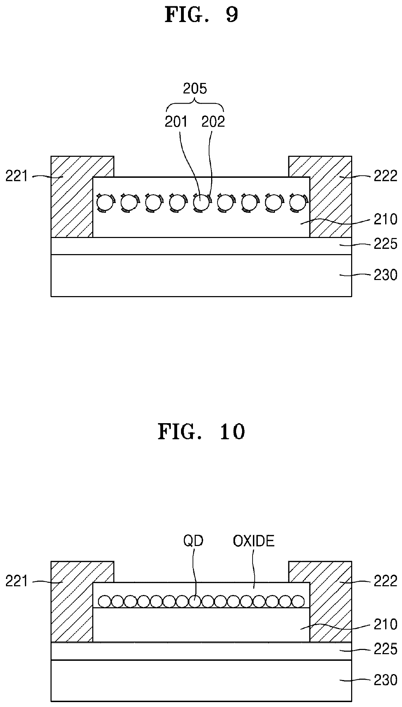

FIG. 9 illustrates an optoelectric device according to an example embodiment.

The optoelectric device according to an example embodiment may include a channel layer 210, a quantum dot structure 205 provided in the channel layer 210, and a first electrode 221 and a second electrode 222 provided at both sides of the channel layer 210. In other words, the first electrode 221 may be provided at a first side of the channel layer 210 and the second electrode 222 may be provided at a second side of the channel layer 210 opposite to the first side. For example, the first electrode 221 may be a source electrode, and the second electrode 222 may be a drain electrode. A third electrode 230 may be provided under the channel layer 210 as shown in FIG. 9. In other words, the third electrode 230 may be provided at a bottom side of the channel layer 210 different from the first side and the second side. The third electrode 230 may be a gate electrode for applying an electric field. An insulating layer 225 may be provided between the channel layer 210 and the third electrode 230. The third electrode 230 may be provided under the channel layer 210 or the third electrode 230 may be provided above the channel layer 210. The optoelectric device may be a phototransistor.

The third electrode 230 may be a conductive substrate or formed of a conductive material in a certain substrate. The third electrode 230 may include a flexible material such as a conductive polymer, or a rigid material, for example, a doped semiconductor (for example, doped silicon). Alternatively, the third electrode 230 may include metal, a metal compound, graphene, or carbon nanotube (CNT). The insulating layer 225 may include a silicon oxide, a silicon nitride, or a silicon oxynitride, or other material layer, for example, a high dielectric material having a dielectric constant greater than that of silicon nitride. Furthermore, the insulating layer 225 may include an organic insulating material such as an insulating polymer. The insulating layer 225 may have a monolayer or multilayer structure.

The photoelectric conversion characteristics of the channel layer 210 may be controlled by applying a certain electric field to the channel layer 210 by using the third electrode 230. The optoelectric device may have not only a photoelectric conversion function, but also a transistor function, and the optoelectric device may be applied to various electronic apparatus as a multifunctional device.

The quantum dot structure 205 may include a quantum dot core 201 and an intermediate 202 provided on a part of a surface of the quantum dot core 201. The channel layer 210 may correspond to the matrix described with reference to FIG. 8. The optoelectric efficiency may be increased by using the quantum dot structure 205.

When light energy (hu), where h = Planck's Constant and u = frequency of light, is irradiated to the channel layer 210, carriers (e-) may be generated in the quantum dot structure 205, and the generated carriers (e-) may be moved between the first and second electrodes 221 and 222 through the channel layer 210.

Next, a description is provided of a comparison between the responsivity of an optoelectric device of a comparative example and an optoelectric device of an example embodiment.

FIG. 10 illustrates a QD phototransistor device according to a comparative example. In the comparative example, a phototransistor has an oxide-QD-oxide channel structure 210 in which monolayer QDs are embedded. A source electrode 221 and a drain electrode 222 are provided at either side of the channel. A gate electrode 230 for applying an electric field to the device is provided. A gate insulating layer 225 is provided between the gate electrode 230 and the channel. The QDs in the comparative example include CdSe QDs. The oxide includes silicon-doped indium zinc oxide (SIZO).

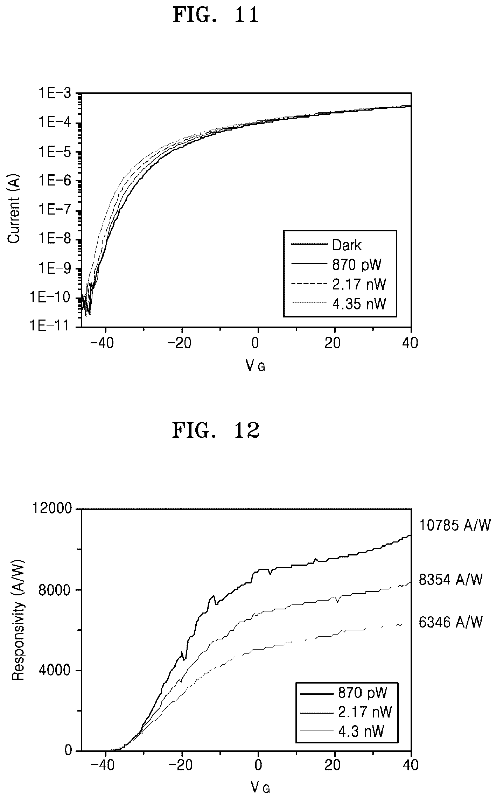

FIG. 11 illustrates the Id-Vg (current-voltage) characteristics of a QD phototransistor device of a comparative example using core quantum dots (core QDs). Id denotes a current, and Vg denotes a voltage. FIG. 12 illustrates the responsivity according to Vg of the QD phototransistor device of a comparative example calculated using the result of FIG. 11.

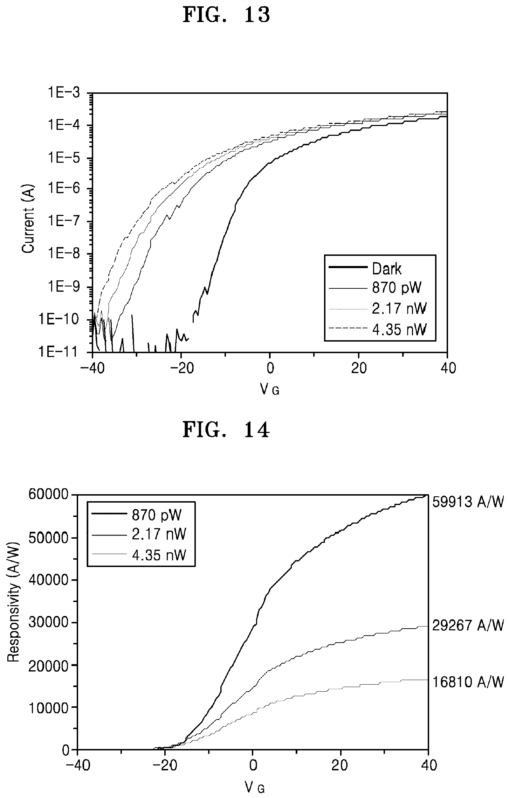

FIG. 13 illustrates the Id-Vg characteristics of the phototransistor device of an example embodiment using the structure of FIG. 9. FIG. 14 illustrates the responsivity according to the Vg of the phototransistor device calculated by using the result of FIG. 13. In an example embodiment, the quantum dot core/intermediate includes CdSe/PbS.

The material of the channel layer 210 used herein includes a silicon-doped indium zinc oxide (SIZO). The incident light is a continuous-wave (CW) laser of a 520 nm wavelength.

For the core CdSe QD device according to a comparative example, responsivity includes 10785 A/W, 8354 A/W, and 6346 A/W for the respective irradiations of light of 870 pW, 2.17 nW, and 4.35 nW. In contrast, for the CdSe/PbS structure according to an example embodiment, responsivity includes 59913 A/W, 29267 A/W, and 16810 A/W for the respective irradiations of light of 870 pW, 2.17 nW, and 4.35 nW. The responsivity of the device having a quantum dot/intermediate structure according to an example embodiment is increased by 3.9 times on average compared to the core QD device according to the comparative example.

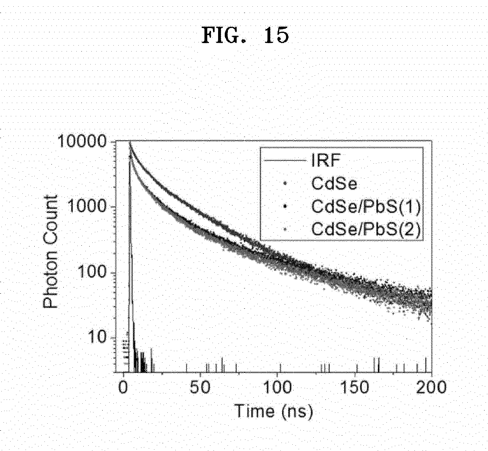

FIG. 15 illustrates time-resolved photoluminescence (PL) data of a CdSe core QD of a comparative example and the quantum dot core/intermediate of CdSe/PbS according to an example embodiment. The thickness of the PbS intermediate of CdSe/PbS(2) is greater than that of CdSe/PbS(1). The PbS intermediate of the CdSe/PbS(1) has a monolayer coverage of about 0.07, and the PbS intermediate of CdSe/PbS(2) has a monolayer coverage of about 0.2.

Referring to FIG. 15, it may be seen that the decay rate is faster in the CdSe/PbS quantum dot core/intermediate according to an example embodiment than in the CdSe core QD of the comparative example. Furthermore, it may be seen that the decay rate increases in the CdSe/PbS(2) compared to the CdSe/PbS(1). The increase of the decay rate denotes an increase of the optoelectric efficiency of the optoelectric device. In other words, in the quantum dot core/intermediate structure according to an example embodiment, the optoelectric efficiency is improved compared to the optoelectric efficiency of the core QD of the comparative example.

Next, a method of growing the PbS intermediate on the CdSe quantum dot is described.

**[Table 1]**

| Sample | Mole ratio (%) | | | | QD | |
|---|---|---|---|---|---|---|
| | S | Se | Cd | Pb | Diameter | PbS layer |
| CdSe | - | 0.460 | 0.540 | - | 3 nm | - |
| CdSe/PbS (1 hr) | 0.051 | 0.466 | 0.467 | 0.016 | 4 nm | 0.066 |
| CdSe/PbS (2hr) | 0.070 | 0.455 | 0.436 | 0.039 | 5 nm | 0.22 |
| CdSe/PbS (300°C, 1hr) | 0.042 | 0.450 | 0.479 | 0.029 | 14 nm | 0.92 |

Table1 shows an inductively coupled plasma (ICP) composition ratio according to the growth times and the temperatures of CdSe and CdSe/PbS QD, the diameter of a quantum dot (QD), and a coverage value indicating a ratio of covering the surface of a quantum dot with a monolayer of the PbS intermediate. The size of a CdSe QD is measured by using transmission electron microscopy (TEM). When the quantum dot core/intermediate is manufactured at 200°C, the diameter of a quantum dot is increased up to about 5 nm for a 2 hour reaction (shown in Table 1 as "CdSe/PbS (2hr)"). When a further reaction at 300°C for 1 hour is performed, the diameter of a quantum dot is increased up to about 14 nm (shown in Table 1 as "CdSe/PbS (300°C, 1hr)").

The composition ratio of each quantum dot is analyzed by ICP. The coverage of a PbS intermediate (for example, the number of coating monolayers) may be seen from the manufactured CdSe/PbS structure by using the composition ratio of Cd and Pb elements and the diameter of a QD.

According to the surface PbS layer number according to the growth temperature and time, at 200°C and 1 hour, about 0.066 monolayer PbS intermediate is coated on the CdSe QD surface, at 200°C and 2 hours, about 0.22 monolayer PbS intermediate is coated, and at 300°C and 1 hour, about 0.92 monolayer PbS intermediate is coated.

The QD may have a diameter of tens of nanometers or lower. An organic ligand or an inorganic ligand may exist on the surface of the QD structure. Furthermore, the QD may be, for example, a colloidal QD.

The optoelectric device according to an example embodiment may be applied to a photodetector, an image sensor, a phototransistor, or a solar cell.

The example embodiments provide an optoelectric device having a structure in which an intermediate is provided in a part of a quantum dot core surface. The optoelectric performance may be improved through the structure.

It should be understood that example embodiments described herein should be considered in a descriptive sense only and not for purposes of limitation. Descriptions of features or aspects within each example embodiment should typically be considered as available for other similar features or aspects in other embodiments. While example embodiments have been described with reference to the figures, it will be understood by those of ordinary skill in the art that various changes in form and details may be made therein without departing from the scope as defined by the following claims.

## Claims

1. An optoelectric device comprising:
a quantum dot core; and
an intermediate provided on at least a part of a surface of the quantum dot core,
wherein the optoelectric device is configured to convert light energy incident upon the optoelectric device to electrical energy.

2. The optoelectric device of claim 1, further comprising a matrix in which the quantum dot core and the intermediate are embedded and through which carriers are transferred, the carriers being generated by the quantum dot core from the light energy incident thereon.

3. The optoelectric device of claim 1 or 2, wherein a ratio of an area of the part of the surface of the quantum dot core to an entire area of the surface of the quantum dot core is in a range of 0.001-0.5, in particular in a range of 0.001-0.3.

4. The optoelectric device of any of the preceding claims, wherein the quantum dot core comprises at least one selected from the group consisting of CdSe, CdTe, InP, InAs, ZnS, ZnSe, and ZnTe.

5. The optoelectric device of any of the preceding claims, wherein the intermediate comprises at least one selected from the group consisting of PbS, PbSe, InP, InAs, and AlAs.

6. The optoelectric device of any of the preceding claims, wherein the intermediate comprises sulfur (S) or oxygen (O) to prevent oxidation of the quantum dot core.

7. The optoelectric device of any of claims 2 to 6, wherein the matrix comprises a semiconductor material.

8. The optoelectric device of any of claims 2 to 7, wherein the matrix comprises an indium gallium zinc oxide (IGZO), a silicon indium zinc oxide (SIZO), or a silicon zinc tin oxide (SZTO).

9. The optoelectric device of any of claims 2 to 7, wherein the matrix comprises a group IV semiconductor material, a group III-V semiconductor material, or a group II-VI semiconductor material, in particular a-Si, p-Si, Ge, GaAs, GaP, GaN, ZnSe, or ZnS.

10. The optoelectric device of any of the preceding claims, wherein,
when a majority of carriers generated by the quantum dot core comprises electrons, a conduction energy band level of the intermediate is lower than a conduction energy band level of the quantum dot core, or
when a majority of carriers generated by the quantum dot core comprises holes, a valence energy band level of the intermediate is higher than a valence energy band level of the quantum dot core.

11. The optoelectric device of any of claims 2 to 10, wherein a first electrode is provided at a first side of the matrix and a second electrode is provided at a second side of the matrix opposite to the first side.

12. The optoelectric device of claim 11, wherein a third electrode is provided on a bottom side of the matrix, the bottom side being different from the first side and the second side, and
wherein an insulating layer is provided between the matrix and the third electrode.

13. The optoelectric device of claim 1 comprising a quantum dot structure comprising the quantum dot core and the intermediate,
wherein the quantum dot core comprises a first material having a first valence band level and a first conduction band level,
wherein the intermediate is a surface layer partially covering the surface of the quantum dot core, the surface layer comprising a second material having a second valence band level and a second conduction band level, and
wherein the first valence band level is less than the second valence band level or the first conduction band level is greater than the second conduction band level.

14. The optoelectric device of claim 13, wherein the first valence band level is less than the second valence band level and/or wherein the first conduction band level is greater than the second conduction band level.

15. The optoelectric device of claim 13 or 14, wherein a ratio of an area of a portion of the surface of the quantum dot core covered by the surface layer to an entire area of the surface of the quantum dot core is in a range of 0.001-0.5, in particular in a range of 0.001-0.3.
